# FASCICULE DE BREVET EUROPEEN

(11) **EP 2 936 634 B1**
(45) Date de publication et mention de la délivrance du brevet: **20.10.2021**
(21) Numéro de dépôt: 13821869.8
(22) Date de dépôt: 17.12.2013
(51) Int. Cl.: H02G 3/12, H02G 3/18

(54) **MODULE D'APPAREILLAGE ÉLECTRIQUE**
ELEKTRISCHES AUSRÜSTUNGSMODUL
ELECTRICAL EQUIPMENT MODULE

(30) Priorité: 20.12.2012 FR 1203509
(43) Date de publication de la demande: 28.10.2015
(73) Titulaire: Legrand France, 87000 Limoges (FR); Legrand SNC, 87000 Limoges (FR)
(72) Inventeur: CAILLE, Jean-Loup, F-87510 Peyrilhac (FR)
(74) Mandataire: Jacobacci Coralis Harle
(86) Numéro de dépôt international: PCT/FR2013/053125
(87) Numéro de publication internationale: WO 2014/096676

(56) Documents cités:
- EP-A1- 2 385 598
- FR-A1- 2 148 098
- US-A- 3 620 404
- US-A- 3 879 101
- US-A- 4 669 804
- US-A1- 2002 185 296
- US-A1- 2010 177 482
- US-B1- 7 160 147
- À Noua--n-Le: "Site industriel", , 7 September 2006 (2006-09-07), XP055529544, Retrieved from the Internet: URL:http://www.capri-codec.com/pdf/Documen tation/catalogueBatiment.pdf [retrieved on 2018-12-03]

## Description

### DOMAINE TECHNIQUE AUQUEL SE RAPPORTE L'INVENTION

La présente invention concerne de manière générale les appareillages électriques à encastrer dans des cavités pratiquées dans des parois.

Elle concerne plus particulièrement un module d'appareillage électrique à engager dans une boîte électrique, selon la revendication 1.

### ARRIERE-PLAN TECHNOLOGIQUE

Actuellement, les appareillages électriques à encastrer présentent tous des architectures similaires.

Un tel appareillage électrique comporte ainsi une boîte électrique ouverte à l'avant et destinée à être fixée au travers d'une ouverture pratiquée dans la cloison creuse, un support d'appareillage en forme de cadre à rapporter sur la face avant ouverte de la boîte électrique, un mécanisme d'appareillage (par exemple d'interrupteur ou de prise de courant) à bloquer dans l'ouverture délimitée par le support d'appareillage, et une plaque de finition à fixer sur le support d'appareillage de telle manière qu'il cache ce dernier et qu'il borde esthétiquement le mécanisme d'appareillage.

Le mécanisme d'appareillage comporte en particulier un socle isolant qui loge des bornes de connexion pour sa connexion au réseau électrique local et qui est fermé à l'avant par un enjoliveur accessible à l'usager (une touche basculante ou enfonçable dans le cas d'un interrupteur ou d'un va-et-vient, un puits de branchement dans le cas d'une prise de courant, ...).

On comprend que le socle isolant, pour pouvoir être engagé dans l'ouverture du support d'appareillage, présente une largeur réduite par rapport au diamètre de la boîte électrique, ce qui restreint le nombre de fonctionnalités que le mécanisme d'appareillage peut embarquer.

Pour installer un tel appareillage électrique dans une ouverture pratiquée dans une cloison creuse, il est par ailleurs nécessaire de mettre en œuvre un nombre important d'opérations.

Il est ainsi nécessaire de tirer au moins une gaine de cheminement de câble au travers de l'ouverture pratiquée dans la cloison creuse, d'engager l'extrémité de chaque gaine dans la boîte électrique, de fixer la boîte électrique dans l'ouverture pratiquée dans la cloison creuse en refoulant chaque gaine dans la cloison creuse, de visser le support d'appareillage sur la boîte électrique, de connecter les fils électriques issus de chaque gaine aux bornes du mécanisme d'appareillage, de bloquer le mécanisme d'appareillage dans le support d'appareillage, et de rapporter la plaque de finition sur le support d'appareillage.

Ces opérations sont longues et fastidieuses à mettre en œuvre.

Le nombre d'éléments nécessaires à la fixation de l'appareillage électrique sur la cloison creuse est en outre important, ce qui génère un surcoût.

On connaît par ailleurs du document US3879101 un mécanisme d'appareillage en deux parties, qui comporte un boîtier arrière prévu pour être fixé à l'intérieur d'une boîte électrique, et un boîtier avant prévu pour être monté sur le boîtier arrière ou démonté de ce boîtier arrière.

Le boîtier arrière comporte des bornes latérales de connexion à des fils électriques issus du réseau électrique local. Il comporte également deux bras adaptés à être fixés par vissage au travers de deux trous prévus dans la boîte électrique.

Le boîtier avant comporte quant à lui deux bornes arrière adaptées à s'enficher dans des alvéoles prévues à l'avant du boîtier arrière. Il comporte également deux flancs percés chacun d'une ouverture pour le vissage du boîtier avant au travers de deux ouvertures prévues sur le boîtier arrière.

Ce mécanisme d'appareillage ne résout pas le problème d'encombrement précité. Il s'avère en outre difficile à installer dans la paroi, notamment car il nécessite l'utilisation d'un nombre important de composants et de vis. Par ailleurs, son assemblage fait apparaître entre le bord du boîtier avant et le bord de la boîte électrique une fente dans laquelle peuvent s'engager des éléments, au détriment de la sécurité électrique de l'ensemble. Enfin, les bras du boîtier arrière, qui permettent la fixation par vissage du boîtier arrière sur la boîte électrique, forment une surépaisseur en saillie à l'avant de la boîte électrique. Cette surépaisseur va à l'encontre du but généralement recherché lors de la conception d'un appareillage électrique à encastrer dans une paroi, à savoir concevoir des appareillages électriques qui font peu saillie à l'avant de cette paroi. Le document EP2385598A1 divulgue un appareillage électrique encastrable dans une boîte d'encastrement.

### OBJET DE L'INVENTION

Afin de remédier aux inconvénients précités de l'état de la technique, la présente invention propose de remplacer le mécanisme d'appareillage et le support d'appareillage par un module d'appareillage d'architecture plus simple, et de volume plus important.

Plus particulièrement, on propose selon l'invention un module d'appareillage tel que défini dans la revendication 1.

Ainsi, la paroi avant présente une fonction de support d'appareillage sans toutefois restreindre la taille du boîtier qui accueille les composants électriques. Elle ne limite donc pas le nombre de fonctionnalités que le boîtier peut embarquer.

Par ailleurs, grâce à l'invention, l'installation du module d'appareillage dans la boîte électrique est facilitée puisqu'elle consiste simplement à rapporter directement ce module d'appareillage dans la boîte électrique, sans l'intermédiaire d'un quelconque support d'appareillage.

D'autres caractéristiques avantageuses et non limitatives du module d'appareillage conforme à l'invention sont définies dans les revendications 2 et suivantes.

### DESCRIPTION DETAILLEE D'UN EXEMPLE DE RÉALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 est une vue schématique en perspective éclatée d'un appareillage électrique à encastrer dans une cloison creuse, sur laquelle apparaît un module d'appareillage électrique selon l'invention, une plaque de finition et une boîte électrique ;
- la figure 2 est une vue schématique en perspective du module d'appareillage électrique de la figure 1, représenté sous un angle différent ;
- les figures 3 à 5 illustrent les étapes d'installation de l'appareillage électrique de la figure 1 dans la cloison creuse ;
- la figure 6 est une vue schématique de face du module d'appareillage électrique et de la boîte électrique ;
- la figure 7 est une vue en coupe selon le plan A-A de la figure 6 ;
- la figure 8 est une vue schématique en perspective éclatée d'une première variante de réalisation de l'appareillage électrique de la figure 1 ;
- la figure 9 est une vue schématique en coupe assemblée de l'appareillage de la figure 8 ;
- les figures 10 et 11 sont des vues schématiques en perspective d'une seconde variante de réalisation du module d'appareillage électrique de la figure 2, représentée sous deux angles différents ; et
- les figures 12 et 13 sont des vues schématiques en perspective d'une troisième variante de réalisation du module d'appareillage électrique de la figure 2, représentée sous deux angles différents.

En préliminaire, on notera que les éléments identiques ou similaires des différentes variantes de réalisation de l'invention représentés sur les différentes figures seront, dans la mesure du possible, référencés par les mêmes signes de référence et ne seront pas décrits à chaque fois.

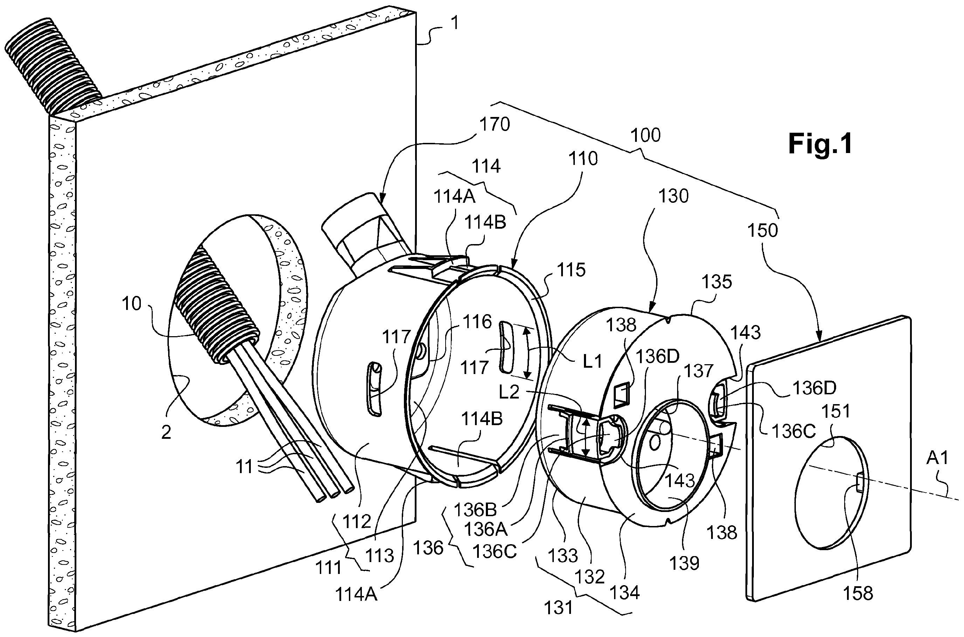

Sur la figure 1, on a représenté un appareillage électrique 100 comprenant un module d'appareillage électrique 130, une boîte électrique 110 et une plaque de finition 150.

Cet appareillage électrique 100 est du type à encastrer dans une cavité 2 pratiquée dans une paroi 1.

La boîte électrique 110 permet alors non seulement de fixer rigidement le module d'appareillage électrique 130 dans la paroi 1 mais également de le protéger.

Par module d'appareillage électrique, on entend tout type de module tel qu'un module de prise de courant, d'interrupteur, de va-et-vient, de variateur électrique, de prise réseau (RJ45), de prise de téléphone (RJ11), de voyant, ou encore de détecteur (de fumée, d'inondation, de température, de mouvement ou de lumière).

Dans le mode de réalisation représenté sur les figures, le module d'appareillage électrique 130 est plus précisément prévu pour être encastré dans une cloison creuse.

On rappelle à ce sujet que, de manière connue, une telle cloison creuse est généralement composée d'une ossature métallique (formée de montants verticaux et de rails horizontaux non représentés) et de panneaux de plâtre 1 rapportés sur l'une au moins des deux faces de l'ossature métallique.

Comme le montre la figure 1, la cavité pratiquée dans cette cloison creuse est ici simplement formée par une ouverture circulaire 2 réalisée à la scie cloche dans l'un des panneaux de plâtre 1.

Dans la description, les termes « avant » et « arrière » seront alors utilisés par rapport à la direction du regard de l'installateur du module d'appareillage électrique 130 dans cette ouverture circulaire 2. Ainsi, les termes avant et arrière désigneront respectivement le lieu tourné vers l'extérieur de la cloison creuse et le lieu tourné vers l'intérieur de la cloison creuse.

Sur la figure 1, on a représenté un mode de réalisation particulier de la boîte électrique 110, qui permet d'illustrer la manière selon laquelle le module d'appareillage électrique 130 peut se fixer dans la cloison creuse.

Cette boîte électrique 110 ne faisant pas en propre l'objet de la présente invention, elle ne sera décrite que brièvement.

Elle comprend un corps 111 qui présente ici une forme générale cylindrique mais qui pourrait bien entendu présenter une forme différente, notamment parallélépipédique.

Ce corps 111 comporte une paroi latérale 112 tubulaire de révolution autour d'un axe A1, qui est fermée à l'arrière par une paroi de fond 113 et qui est ouverte vers l'avant. Le corps 111 délimite ainsi un logement intérieur d'accueil du module d'appareillage électrique 130.

Pour sa fixation dans l'ouverture circulaire 2 pratiquée dans le panneau de plâtre 1, le corps 111 de la boîte électrique 110 comporte un trottoir extérieur 115 qui longe extérieurement le bord de l'ouverture avant de la paroi latérale 112 et qui est adapté à prendre appui contre la face avant du panneau de plâtre 1, tout autour de l'ouverture circulaire 2. Ainsi, ce trottoir extérieur 115 permet de bloquer le corps 111 de la boîte électrique 110 vers l'arrière.

Pour le bloquer vers l'avant, la paroi latérale 112 comporte des moyens de fixation qui sont adaptés à s'accrocher à l'arrière du panneau de plâtre 1.

Ces moyens de fixation sont ici formés par des moyens d'encliquetage 114 comportant deux pattes de flexion 114B diamétralement opposées qui sont découpées dans la paroi latérale 112 du corps 111 et qui portent chacune sur leurs faces externes une dent d'encliquetage 114A.

Dans ce mode de réalisation particulier de la boîte électrique 110, cette dernière est équipée d'un bornier de connexion 116 qui est ici fixé sur la face intérieure de sa paroi de fond 113.

Ce bornier de connexion 116 est prévu pour, d'une part, être connecté à des fils électriques 11 issus du réseau électrique local, et, d'autre part, présenter des zones de connexion auxquelles le module d'appareillage électrique 130 peut se connecter.

Ici, les fils électriques 11 issus du réseau électrique local sont au nombre de trois et débouchent d'une gaine de cheminement 10 annelée en plastique souple située à l'intérieur de la cloison creuse.

Ils sont engagés à l'intérieur de la boîte électrique 110, jusqu'au bornier de connexion 116, via une ouverture d'insertion prévue à cheval sur la paroi latérale 112 et sur la paroi de fond 113 du corps 111 de la boîte électrique 110.

Telle que représentée sur la figure 1, la gaine de cheminement 10 est connectée au corps 111 de la boîte électrique 110 au moyen d'un embout 170 en plastique souple.

Cet embout 170 présente à cet effet une forme tubulaire, avec une première partie d'extrémité dans laquelle est engagée une extrémité de la gaine de cheminement 10, et une seconde partie d'extrémité qui s'accroche au bord de l'ouverture d'insertion précitée.

Comme le montre la figure 1, le module d'appareillage 130 à rapporter dans cette boîte électrique 110 est conçu pour offrir à l'utilisateur la fonction électrique souhaitée. Il se présente sous la forme d'un bloc « tout en un », adapté à être rapporté directement dans le corps 111 de la boîte électrique 110 et à se connecter automatiquement au bornier de connexion 116 de la boîte électrique 110.

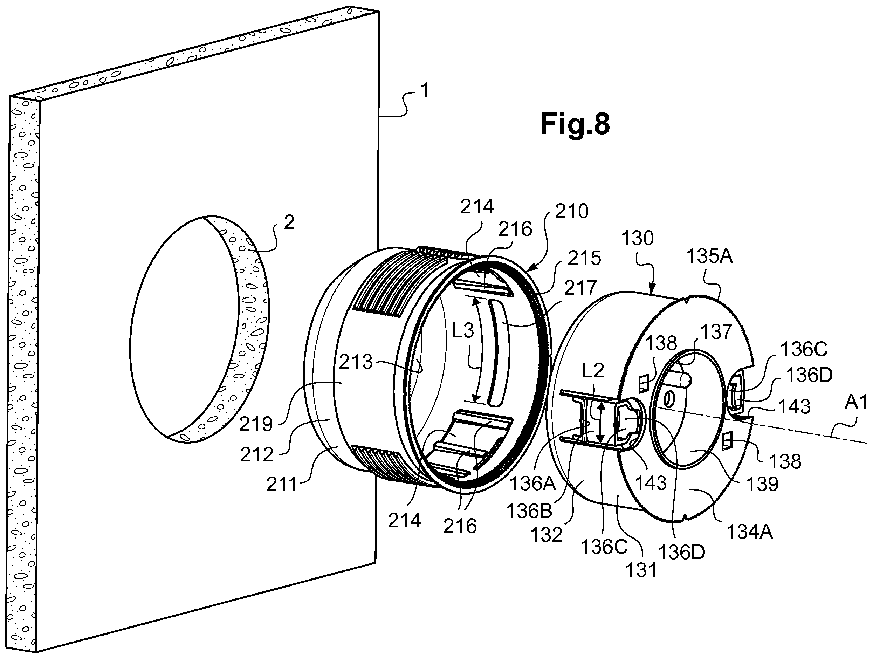

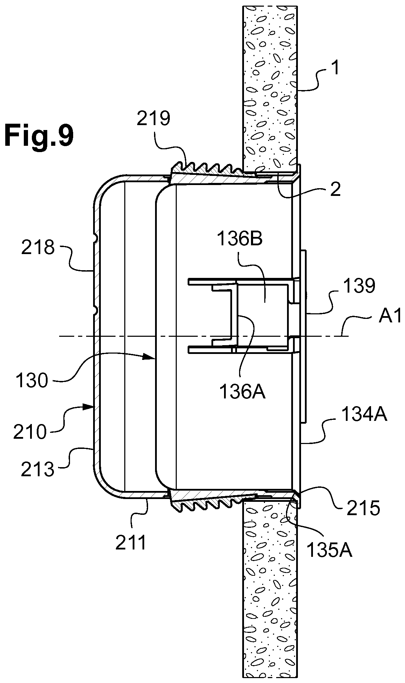

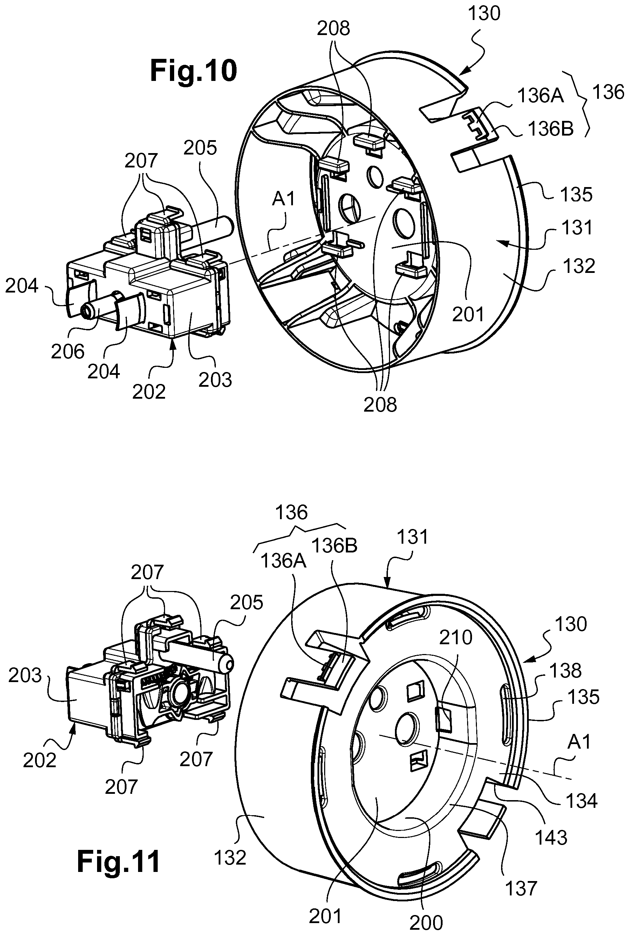

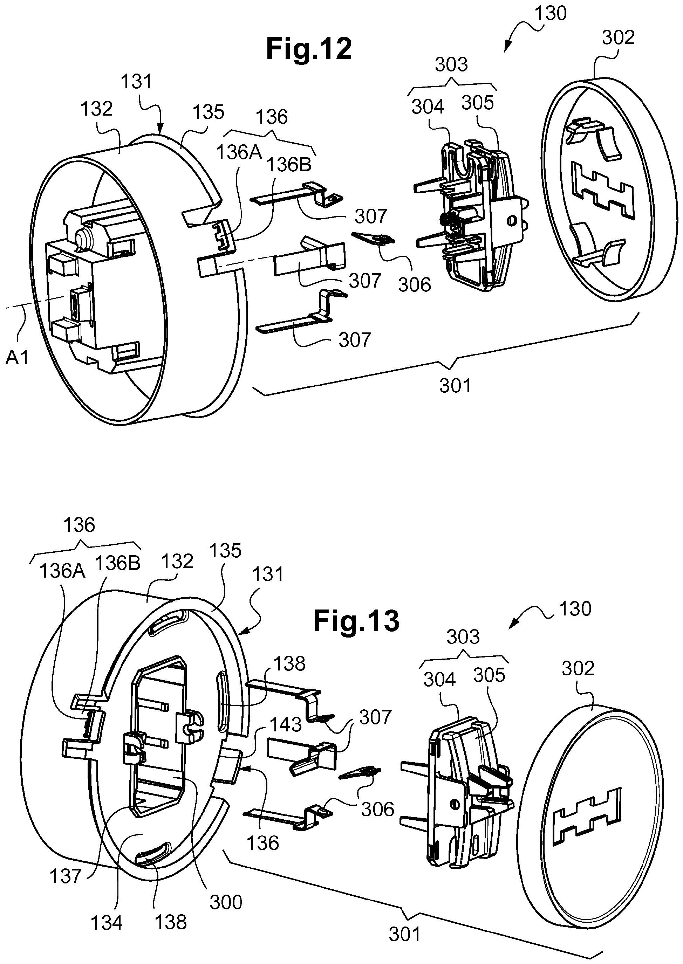

Sur les figures 1 à 7, on a représenté un premier mode de réalisation de ce module d'appareillage 130. Sur les figures 8 et 9, sur les figures 10 et 11, et sur les figures 12 et 13, on a représenté trois variantes de réalisation de ce module d'appareillage 130.

Sur les figures 1, 8 et 10, le module d'appareillage électrique 130 présente une fonction de prise de courant, tandis que sur la figure 12, il présente une fonction d'interrupteur.

Comme le montrent les figures 1, 8, 10 et 12, le module d'appareillage électrique 130 comporte quoi qu'il en soit un boîtier 131 en matériau isolant qui loge un mécanisme d'appareillage (ici un mécanisme de prise de courant ou d'interrupteur) de telle manière que seul l'enjoliveur (139 sur la figure1) de ce mécanisme d'appareillage émerge à l'avant de ce boîtier 131.

Ce boîtier 131 comprend une paroi latérale 132 qui délimite un espace intérieur.

Dans le mode de réalisation représenté sur la figure 1 et dans la première variante représentée sur la figure 8, cette paroi latérale 132 est fermée à l'arrière par une paroi arrière 133, tandis que dans les variantes représentées sur les figures 10 et 12, elle est ouverte vers l'arrière.

Le boîtier 131 comporte également un trottoir extérieur 135 qui borde à l'avant la paroi latérale 132 et qui est conçu pour s'appuyer contre la face avant du trottoir extérieur 115 de la boîte électrique 110.

Selon la présente invention, le boîtier 131 comporte également une paroi avant 134 qui ferme à l'avant ledit espace intérieur et qui comprend, d'une part, une fenêtre d'accès 137 à l'intérieur du boîtier 131, qui est destinée à être fermée par ledit enjoliveur 139, et, d'autre part, des moyens d'assujettissement 138 d'une plaque de finition 150.

La fenêtre d'accès 137 pratiquée dans la paroi avant 134 du boîtier 131 présente une taille inférieure à celle de cette paroi avant 134.

Dans le mode de réalisation de la figure 1, cette fenêtre d'accès 137 présente un contour circulaire et est décentrée par rapport au contour circulaire de la paroi avant 134.

Dans les variantes de réalisation des figures 8 et 11, cette fenêtre d'accès 137 présente un contour circulaire centré par rapport au contour circulaire de la paroi avant 134.

Dans la variante de réalisation de la figure 13, cette fenêtre d'accès 137 présente un contour rectangulaire centré par rapport au contour circulaire de la paroi avant 134.

Comme le montrent les figures 1, 2, 8, 10 et 12, la paroi latérale 132 du boîtier 131 présente une forme générale identique à celle de la boîte électrique 110. Elle présente alors ici une forme sensiblement cylindrique de révolution autour d'un axe A1.

Pour sa fixation dans la boîte électrique 110, le boîtier 131 du module d'appareillage électrique 130 comporte, outre le trottoir extérieur 135 qui adapté à prendre appui contre la face avant du trottoir extérieur 115 de la boîte électrique 110, des moyens d'accroche 136. Il comporte également des moyens de centrage dans la boîte électrique 110. Ici, ces moyens de centrage sont formés par le trottoir extérieur 135, qui présente à cet effet une forme adéquate.

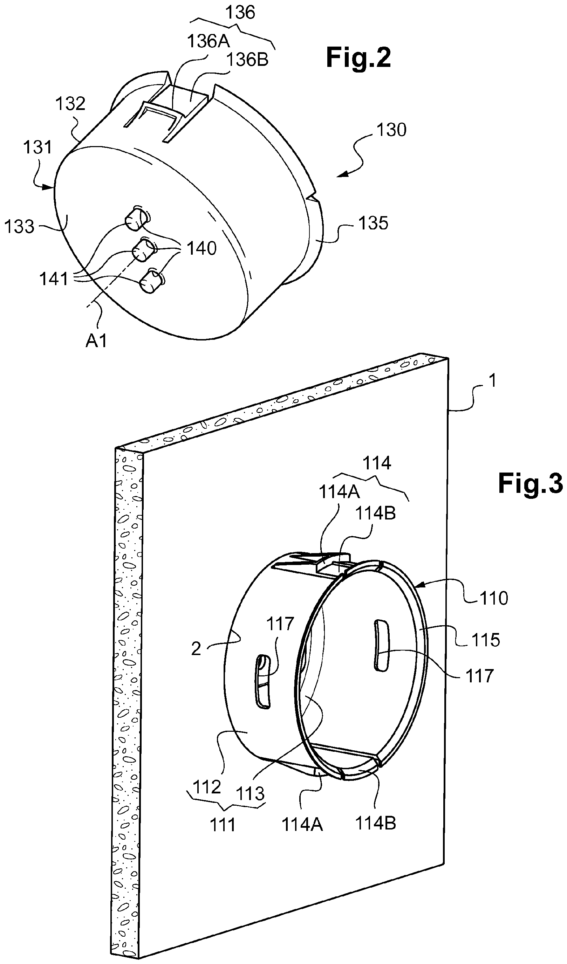

Comme le montrent les figures 2, 8, 10 et 12, le trottoir extérieur 135 présente en effet une face arrière inclinée vers l'extérieur, qui présente donc une forme tronconique. L'arête intérieure prévue à la jonction de la paroi latérale 112 et du trottoir extérieur 115 de la boîte électrique 110 est alors chanfreinée en correspondance, pour présenter une forme tronconique identique. De cette manière, lorsque le boîtier 131 du module d'appareillage électrique 130 est engagé dans la boîte électrique 110, son trottoir extérieur 135 s'appuie contre l'arête chanfreinée de la boîte électrique 110, ce qui permet de centrer le boîtier 131 selon l'axe A1 de la boîte électrique 110.

Les moyens d'accroche sont quant à eux ici formés par des moyens d'encliquetage 136 qui comportent deux pattes de flexion 136B qui se découpent dans la paroi latérale 132 du boîtier 131, qui portent chacune sur leurs faces externes une dent d'encliquetage 136A, et qui sont manœuvrables manuellement pour pouvoir être décrochées de la boîte électrique 110. Dans le mode de réalisation représenté sur la figure 1 et dans la première variante représentée sur la figure 8, il est prévu des leviers 136C pour faciliter la manœuvre de ces deux pattes de flexion 136B.

Comme le montrent les figures 1, 8, 11 et 13, les deux pattes de flexion 136B sont situées de manière diamétralement opposée par rapport à l'axe A1. Elles s'étendent en longueur depuis le bord avant de la paroi latérale 132 du boîtier 131, vers l'arrière. Chaque patte de flexion 136B présente une forme de rectangle dont trois des bords sont libres et dont le quatrième bord, à savoir ici le bord arrière, forme la racine de la patte de flexion 136B en ce sens qu'il se raccorde au reste de la paroi latérale 132 du boîtier 131 pour former une charnière.

Chaque dent d'encliquetage 136A est alors située à distance de la charnière. Chaque dent d'encliquetage 136A présente une face avant plane et orthogonale à l'axe A1 et une face arrière inclinée par rapport à l'axe A1.

La face arrière de chaque dent d'encliquetage 136A forme une rampe permettant à la patte de flexion 136B de se déformer élastiquement vers l'intérieur lorsque le boîtier 131 est engagé dans la boîte électrique 110, de manière que la dent d'encliquetage 136A correspondante ne forme pas obstacle à l'engagement du module d'appareillage électrique 130 à l'intérieur de la boîte électrique 110.

La face avant de chaque dent d'encliquetage 136A est quant à elle prévue pour s'accrocher au bord avant d'une fenêtre rectangulaire 117 prévue en correspondance dans la paroi latérale 112 de la boîte électrique 110, lorsque le trottoir extérieur 135 du module d'appareillage électrique 130 prend appui contre la face avant du trottoir extérieur 115 de la boîte électrique 110 (ce qui assure le référencement du module par rapport à la boîte). L'orientation de la face avant de chaque dent d'encliquetage 136 et du bord avant de chaque fenêtre rectangulaire 117 (dans un plan orthogonal à l'axe A1) permet d'assurer une bonne fixation du module d'appareillage 130 dans la boîte électrique 110, et notamment une bonne résistance à l'arrachement lorsqu'un effort de traction est exercé selon l'axe A1 sur le module d'appareillage 130.

Ici, il est prévu deux fenêtres rectangulaires 117 distinctes, qui présentent chacune une longueur L1 identique à la longueur L2 de la face avant des dents d'encliquetage 136A. Ainsi, lorsque les dents d'encliquetage 136A s'accrochent aux bords avant des fenêtres rectangulaires 117, les côtés de ces dents d'encliquetage 136A s'appuient contre les bords latéraux des fenêtres rectangulaires 117, ce qui permet de bloquer tout mouvement de rotation du boîtier 131 par rapport à la boîte électrique 110 autour de l'axe A1.

Ici, comme le montrent les figures 1, 6, 7 et 8, chacun des leviers 136C prévus pour manœuvrer les pattes de flexion 136B se présente sous la forme d'une anse raccordée à cette patte de flexion 136B.

Chaque anse 136C comporte une paroi semi-circulaire, qui se raccorde par ses deux bords d'extrémité latéraux à la face interne de la patte de flexion 136B, qui est fermée à l'arrière par un fond et qui est ouverte à l'avant pour délimiter une cavité 136D dans laquelle l'installateur peut insérer un doigt.

Il est alors prévu, en creux dans le bord de la paroi avant 134 du boîtier 131 et à distance de la fenêtre d'accès 137, deux encoches 143 diamétralement opposées permettant d'accéder à ces cavités 136D. Ces encoches 143 (qui sont également visibles sur les figures 11 et 13) permettent de délimiter des dégagements permettant aux pattes de flexion 13B de fléchir vers l'intérieur du boîtier 131.

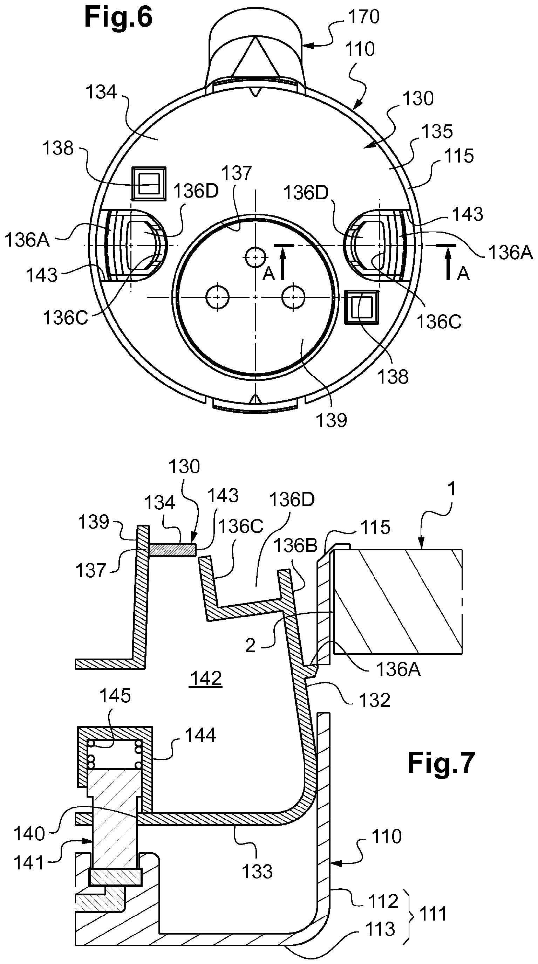

Ainsi, comme le montrent les figures 6 et 7, en insérant deux doigts dans ces deux cavités 136D et en pinçant les deux leviers 136C l'un vers l'autre, l'installateur peut manœuvrer les pattes de flexion 136B. Il peut ainsi forcer chaque dent d'encliquetage 136A à se dégager de chaque fenêtre rectangulaire 117 de la boîte électrique 110, ce qui permet d'extraire le boîtier 131 hors de la boîte électrique 110.

Comme le montrent les figures 1, 8, 11 et 13, la paroi avant 134 du boîtier 131 présente également, à distance de la fenêtre d'accès 137 et des encoches 143, des trous 138 permettant d'assujettir la plaque de finition 150 au boîtier 131.

Dans le premier mode de réalisation représenté sur la figure 1 et dans la première variante représentée sur la figure 8, il est prévu deux trous 138.

La plaque de finition 150 est ici prévue pour border l'enjoliveur 139 du mécanisme d'appareillage et pour cacher esthétiquement le boîtier 131 du module d'appareillage électrique 130. Elle présente à cet effet ici une forme carrée, avec une ouverture circulaire 151 d'accès à l'enjoliveur 139.

Elle comporte, en saillie de sa face arrière, deux plots d'encliquetage 158 prévus pour s'engager au travers des trous 138 carrés pratiqués dans la paroi avant 134 du boîtier 131, et pour s'accrocher à la face arrière de celle-ci.

Préférentiellement, ces plots d'encliquetage 158 et/ou ces trous 138 seront crantés de telle manière que la plaque de finition 150 puisse s'accrocher à différentes hauteurs par rapport au module d'appareillage 130. En effet, il arrive qu'après avoir fixé la boîte électrique 110 dans le panneau de plâtre, on recouvre ce dernier d'un revêtement épais (papier peint, enduit, ...). Les crans permettront alors à la plaque de finition 150 de simultanément s'appuyer contre le revêtement et s'accrocher au module d'appareillage 130.

Comme le montrent plus particulièrement les figures 6 et 7, puisque le mécanisme d'appareillage présente une fonction de prise de courant, l'enjoliveur 139 forme un puits de réception d'une fiche électrique.

Le fond de l'enjoliveur 139 est donc percé de deux premières ouvertures de passage des broches de la fiche électrique et d'une troisième ouverture de passage d'une broche de terre du mécanisme d'appareillage.

Comme le montre la figure 7, la partie interne du mécanisme d'appareillage, qui est logée à l'intérieur du boîtier 131, comporte alors ici trois bornes de connexion électrique 141. Ces trois bornes de connexion électrique 141 sont respectivement connectées à la broche de terre et à deux alvéoles de réception des broches de la fiche électrique (situées à l'arrière des deux premières ouvertures précitées). Elles sont par ailleurs conçues pour se connecter au bornier de connexion 116 de la boîte électrique 110.

Comme le montrent les figures 2 et 7, la paroi arrière 133 du boîtier 130 présente à cet effet trois ouvertures d'entrée 140 prévues pour permettre la connexion des bornes de connexion électrique 141 au bornier de connexion 116 de la boîte électrique 110.

Ces trois ouvertures d'entrée 140 présentent ici des formes circulaires. Elles permettent ici aux bornes de connexion électrique 141 de faire saillie à l'extérieur du boîtier 131.

En pratique, les bornes de connexion électrique 141 sont ici des bornes à piston, ce qui assure une bonne connexion entre ces bornes de connexion électrique 141 et le bornier de connexion 116 de la boîte électrique 110.

Elles se présentent alors globalement sous la forme de plots cylindriques qui sont montés à translation dans des logements d'accueil prévus à l'intérieur du boîtier 131, selon des axes parallèles à l'axe A1, et qui sont rappelés en saillie à l'extérieur du boîtier 131 par des ressorts de compression 145 logés dans ces logements d'accueil.

Ces logements d'accueil sont ici délimités par des cloisons internes 144 qui viennent de formation avec la paroi arrière 133 et/ou avec la paroi latérale 132 du boîtier 131.

Pour fermer à l'avant et à l'arrière cette paroi latérale 132, la paroi arrière 133 et la paroi avant 134 du boîtier 131 sont alors de formes sensiblement circulaires. La paroi avant 134 est ainsi bordée sur sa périphérie par le trottoir extérieur 135.

Ces parois arrière 133 et avant 134 sont monoblocs. Elles sont ici réalisées d'une seule pièce par moulage en matière plastique. Tandis que l'une d'entre elles vient de formation avec une partie au moins de la paroi latérale 132, l'autre est encliquetée sur la paroi latérale 132.

L'installation de l'appareillage électrique 100 dans l'ouverture circulaire 2 pratiquée dans le panneau de plâtre 1 est alors réalisée de la manière suivante.

L'extrémité libre de la gaine de cheminement 10 est tout d'abord tirée à l'extérieur de la cloison creuse, au travers de l'ouverture circulaire 2.

L'installateur engage alors l'embout 170 à l'extrémité de cette gaine de cheminement 10, en prenant soin de passer les trois fils électriques 11 au travers de cet embout 170.

L'installateur engage les extrémités libres des trois fils électriques 11 dans la boîte électrique 110, par l'ouverture d'insertion, de manière à pouvoir les connecter au bornier de connexion 116.

Comme le montre la figure 3, il rapporte ensuite la boîte électrique 110 dans l'ouverture circulaire 2 pratiquée dans le panneau de plâtre 1 en prenant soin que ses dents d'encliquetage 114A s'accrochent bien à l'arrière du panneau de plâtre 1.

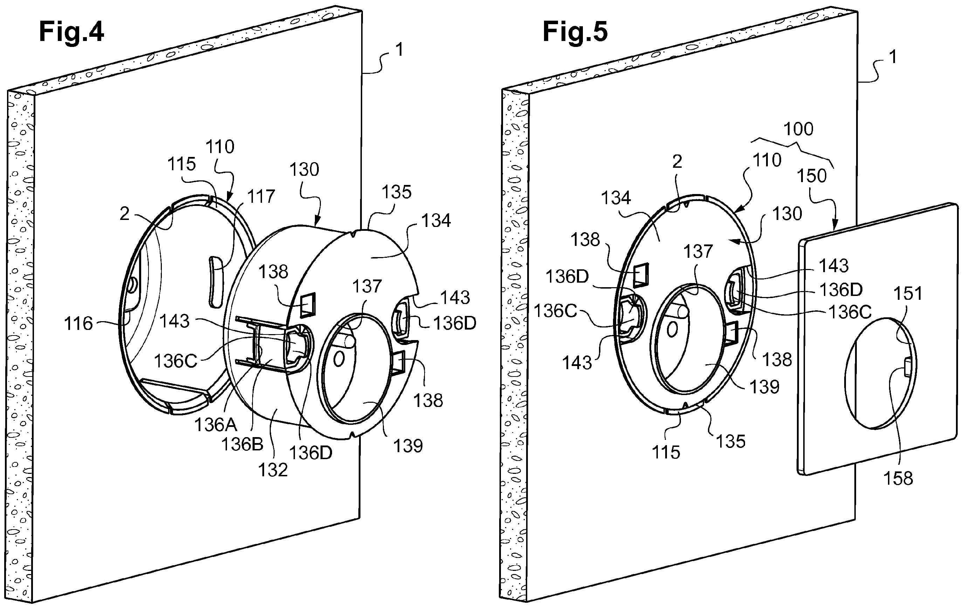

Comme le montre la figure 4, il rapporte alors directement le module d'appareillage électrique 130 dans la boîte électrique 110 en prenant soin que ses dents d'encliquetage 136A s'accrochent bien aux bords avant des fenêtres 117 prévues dans la paroi latérale 112 de la boîte électrique 110.

Enfin, comme le montre la figure 5, il rapporte la plaque de finition 150 sur la paroi avant 134 du boîtier 131 du module d'appareillage 130 de telle manière que ses plots d'encliquetage 158 se clipsent dans les trous 138 de cette paroi avant 134 et que son ouverture circulaire 151 borde l'enjoliveur 139 du module d'appareillage électrique 130.

Par la suite, il peut arriver que l'utilisateur souhaite remplacer le module d'appareillage 130, par exemple par un nouveau module d'appareillage optimisé.

Pour ce faire, l'utilisateur retire la plaque de finition, par exemple au moyen d'un tournevis, puis comme le montrent les figures 6 et 7, il manœuvre les leviers 236C pour dégager les dents d'encliquetage 236A des fenêtres rectangulaires 117 de la boîte électrique 110. De cette manière, il peut alors retirer l'ancien module d'appareillage 130 facilement, puisque la déconnexion de ses bornes de connexion électrique 141 se fait automatiquement.

La présente invention n'est nullement limitée au mode de réalisation décrit et représenté sur les figures 1 à 7, mais l'homme du métier saura y apporter toute variante conforme à son esprit.

Ainsi, sur les figures 8 et 9, on a représenté une première variante de réalisation du module d'appareillage 130 et de la boîte électrique 210.

Dans cette variante, le module d'appareillage 130 présente une forme homologue de celle du module d'appareillage représenté sur la figure 1.

Il se distingue de celui-ci par la forme de son trottoir extérieur 135A dont la face arrière est crantée, par la forme de sa paroi avant 134A dont la fenêtre 137A est centrée sur l'axe A1, et par la forme de ses bornes de connexion (qui seront décrites ultérieurement).

Le corps 211 de la boîte électrique 210 présente en revanche une forme sensiblement différente de celle du corps 111 de la boîte électrique 110 représentée sur la figure 1.

Il comporte ainsi une paroi latérale 212 sensiblement cylindrique de révolution autour de l'axe A1, une paroi de fond 213 circulaire et un trottoir extérieur 215 qui longe extérieurement le bord de l'ouverture avant de la paroi latérale 212.

Ici, l'arête intérieure prévue à la jonction de la paroi latérale 212 et du trottoir extérieur 215 est chanfreinée et crantée, de manière à pouvoir coopérer avec les crans du trottoir extérieur 135A du module d'appareillage électrique 130.

Les fenêtres rectangulaires 217 prévues dans la paroi latérale 212 présentent par ailleurs des longueurs L3 très supérieures aux longueurs L1 des dents d'encliquetage 136A du module d'appareillage électrique 130, de manière qu'elles ne bloquent pas ce dernier en rotation autour de l'axe A1.

Ainsi, il est possible de régler la position angulaire du module d'appareillage électrique 130 par rapport à la boîte électrique 210 autour de l'axe A1. Le blocage en position angulaire du module d'appareillage électrique 130 dans la position souhaitée est alors assuré par les crans du trottoir extérieur 135A du module d'appareillage électrique 130 qui coopèrent avec ceux de la boîte électrique 110.

Ici, les moyens de fixation de la boîte électrique 110 dans l'ouverture circulaire 2 prévue dans le panneau de plâtre 1 sont d'un type particulier.

Ils comportent en l'espèce quatre volets 214 rectangulaires découpés dans la paroi latérale 212 de la boîte électrique 210, dont trois des bords sont libres et dont le quatrième bord, à savoir ici le bord avant, se raccorde au reste de la paroi latérale 212 par deux pattes formant charnière.

Ces quatre volets 214 comportent chacun, en saillie de leurs faces intérieures, des rampes 216 dont l'épaisseur croît depuis l'avant vers l'arrière. Ainsi, lorsque le module d'appareillage électrique 130 est rapporté dans la boîte électrique 210, il appuie sur ces rampes 216, ce qui permet de déployer les volets 214 en saillie de la face externe de la paroi latérale 212.

Ici, la paroi latérale 212 porte un bandeau périphérique 219 en matériau compressible, qui recouvre notamment les volets 214. Ce bandeau périphérique 219 présente ici, au niveau de chacun des volets 214, des nervures parallèles en saillie.

De cette manière, comme le montre la figure 9, lorsqu'ils se déploient, les volets 214 compriment les nervures du bandeau périphérique 219 contre le bord de l'ouverture circulaire 2 pratiquée dans le panneau de plâtre 1, ce qui permet de fixer la boîte électrique 210 dans cette ouverture circulaire 2.

Ici, la boîte électrique 210 est dépourvue de bornier de connexion. Sa paroi de fond 213 comporte toutefois un opercule défonçable 218 qui permet de dégager un passage pour la gaine de cheminement 10.

On comprend donc que dans cette variante, les fils électriques 11 issus de cette gaine de cheminement 10 sont directement connectés aux bornes de connexion électrique du module d'appareillage 130.

Les bornes de connexion électrique du module d'appareillage 130 (non représentées sur les figures) pourront alors être du type automatique, en se présentant par exemple sous la forme de lames-ressorts pliées de telle manière qu'elles délimitent des conduits d'insertion et de blocage des extrémités dénudées des fils électriques.

Elles pourront en variante être du type semi-automatique, en se présentant par exemple sous la forme de lames métalliques équipées de leviers de manœuvre, ces leviers de manœuvre étant alors adaptés à repousser les extrémités des fils électriques 11 contre ces lames métalliques pour les dénuder automatiquement et pour établir la connexion électrique.

Elles pourront en variante être du type manuel, en se présentant par exemple sous la forme de lames métalliques équipées de vis qui, une fois vissées, comprimeront les extrémités dénudées des fils électriques contre ces lames métalliques pour établir la connexion électrique.

Selon une autre variante de l'invention non représentée sur les figures, on pourrait prévoir que les moyens de fixation du module d'appareillage électrique dans la boîte électrique soient, non pas des moyens d'encliquetage, mais plutôt des vis de griffe dont les griffes seraient adaptées à s'accrocher à la paroi latérale de la boîte électrique à la faveur du vissage des vis.

Selon une autre variante, ces moyens de fixation pourraient être formés par des aimants.

Selon encore une autre variante de l'invention, les bornes de connexion électrique prévues dans le module d'appareillage électrique pourraient être formées par des plots fixes et indéformables, situés à l'intérieur du boîtier (auquel cas le bornier de connexion prévu au fond de la boîte électrique comportera des broches adaptées à traverser les ouvertures d'entrée prévues dans le fond du boîtier pour se connecter à ces bornes).

Sur les figures 10 et 11 d'une part, et sur les figures 12 et 13 d'autre part, on a représenté en détail les seconde et troisième variantes de réalisation du module d'appareillage 130.

Dans ces variantes, le module d'appareillage 130 est adapté à être rapporté à l'intérieur d'une boîte électrique 110 du type de celle représentée sur la figure 1, puis à être recouvert partiellement par une plaque de finition du type de celle représentée sur la figure 1.

Dans ces deux variantes, le boîtier 131 du module d'appareillage électrique 130 comporte donc une paroi latérale 132 (ici encore cylindrique de révolution) qui est fermée à l'avant par une paroi avant 134, mais qui est ouverte à l'arrière. Le fonctionnement de ces deux variantes de réalisation du module d'appareillage électrique 130 est identique à celui exposé supra et ne modifie en rien le principe d'utilisation de l'appareillage électrique.

Son principal avantage est de permettre de fabriquer des boîtiers 131 avec un volume de matière première restreint.

Dans la seconde variante de réalisation du module d'appareillage 130 représentée sur les figures 10 et 11, la paroi avant 134 du boîtier 131 présente un renfoncement 200 en creux qui s'étend à partir du bord de la fenêtre 137, vers l'arrière. Il présente une forme tubulaire et est fermé à l'arrière par un fond 201 dans lequel sont prévues des ouvertures de passage de broches.

La paroi tubulaire de ce puits d'insertion comporte deux fenêtres latérales 210 opposées, permettant la fixation d'un enjoliveur (non représenté) à l'intérieur de ce renfoncement 200. Cet enjoliveur sera alors prévu pour délimiter un puits d'insertion d'une fiche électrique, afin de conférer au module d'appareillage 130 sa fonction de prise de courant.

Dans cette seconde variante de réalisation du module d'appareillage 130, il est prévu quatre trous 138 permettant d'assujettir une plaque de finition au boîtier 131.

Ces quatre trous 138 se présentent plus précisément ici sous la forme de quatre fentes en arc-de-cercle autour de l'axe A1, dont les bords intérieurs portent des nervures d'accrochage.

La plaque de finition (non représentée) comporte en correspondance deux ou quatre pattes d'encliquetage adaptées à s'engager dans ces trous 138 pour s'encliqueter sur ces nervures d'accrochage.

Le mécanisme d'appareillage 202 logé à l'intérieur de la paroi latérale 132 du boîtier 131 (ici un mécanisme de prise de courant) comporte un socle isolant 203 à l'intérieur duquel sont logés trois bornes de connexion électrique.

Deux de ces bornes de connexion comportent, à l'intérieur du socle 203, des alvéoles de réception des broches de la fiche électrique, et, à l'arrière du socle 203, des broches 204 de connexion au bornier de connexion 116 de la boîte électrique 110. La troisième de ces bornes de connexion comporte, à l'avant du socle 203, une broche de terre 205, et, à l'arrière du socle 203, et une broche 206 de connexion au bornier de connexion 116 de la boîte électrique 110.

Le socle 203 est équipé de moyens de fixation dans le boîtier 131. Ici, ces moyens de fixation se présentent sous la formes de pattes d'encliquetage 207 adaptées à s'accrocher dans des cavités prévues dans des languettes 208 qui s'étendent à partir de la face arrière du fond du renfoncement 200 prévu dans la paroi avant 134 du boîtier 131.

Dans la troisième variante de réalisation du module d'appareillage 130 représentée sur les figures 12 et 13, la paroi avant 134 du boîtier 131 présente un renfoncement 300 en creux qui s'étend à partir du bord de la fenêtre 137, vers l'arrière, et qui délimite un logement pour le mécanisme d'appareillage 301.

Ce renfoncement 300 présente ici une forme globalement parallélépipédique.

Le mécanisme électrique 301, qui est ici un mécanisme d'interrupteur, comporte un enjoliveur en deux parties. Cet enjoliveur est constitué d'une touche basculante (non visible sur les figures) qui est prévue pour être montée mobile sur le boîtier 131, et une plaque arrière 302 qui est fixée sur le boîtier 131. Le mécanisme électrique 301 comporte également un système à bascule 303 dont une partie fixe 304 est fixée au boîtier 131 et dont une partie mobile 305 est entraînée par la touche basculante, trois bornes fixes 307, et un contact mobile 306 entraîné par le système à bascule 303 pour établir ou ouvrir le contact électrique entre les bornes fixes 307.

Ce mécanisme électrique 301 est prévu pour être logé à l'intérieur du boîtier 131 de telle manière que son enjoliveur se place à l'avant du renfoncement 300 (et ferme ainsi l'accès à la fenêtre 137) et que les bornes fixes 307 émergent en partie à l'arrière de ce renfoncement 300.

Les parties de ces bornes fixes 307 qui émergent à l'arrière du renfoncement 300 présentent ici des formes de languettes prévues pour se connecter au bornier de connexion 116 de la boîte électrique 110.

## Revendications

1. Module d'appareillage électrique (130) à engager dans une boîte électrique (110), comportant un mécanisme de prise de courant ou d'interrupteur ou de va-et-vient, et un boîtier (131) en matériau isolant qui comprend :
- une paroi latérale (132) qui délimite un espace intérieur (142) de réception d'au moins un élément de connexion électrique (141), et
- un trottoir extérieur (135) qui borde à l'avant la paroi latérale (132) pour s'appuyer contre le bord avant (115) de ladite boîte électrique (110),
- un enjoliveur (139) qui confère au module d'appareillage électrique (130) sa fonction électrique et qui comporte soit des ouvertures de passage de broches d'une fiche électrique, soit une touche, une plaque de finition (150) qui borde l'enjoliveur (139) du mécanisme d'appareillage, le boîtier (131) comporte une paroi avant (134) qui comprend :
- une fenêtre d'accès (137) à chaque élément de connexion électrique (141), fermée par ledit enjoliveur (139), **caractérisé en ce que** la paroi avant (134) ferme à l'avant ledit espace intérieur (142), vient de formation d'une seule pièce monobloc avec une partie au moins de ladite paroi latérale (132) et comprend des moyens d'assujettissement (138) de la plaque de finition (150).

2. Module d'appareillage électrique (130) selon la revendication précédente, dans lequel lesdits moyens d'assujettissement (138) sont situés entre ladite fenêtre d'accès (137) et ledit trottoir extérieur (135).

3. Module d'appareillage électrique (130) selon l'une des revendications précédentes, dans lequel ladite fenêtre d'accès (137) est décentrée par rapport au contour de ladite paroi avant (134).

4. Module d'appareillage électrique (130) selon l'une des revendications précédentes, dans lequel ladite paroi latérale (132) présente une forme sensiblement cylindrique de révolution autour d'un axe (A1).

5. Module d'appareillage électrique (130) selon l'une des revendications précédentes, dans lequel ledit boîtier (131) comporte au moins un organe déployable (136A) pour la fixation du boîtier (131) à ladite boîte électrique (110), qui est mobile entre une position rentrée dans laquelle il n'entrave pas l'introduction du boîtier (131) dans ladite boîte électrique (110) et une position déployée dans laquelle il est adapté à s'accrocher à ladite boîte électrique (110).

6. Module d'appareillage électrique (130) selon la revendication précédente, dans lequel ledit organe déployable (136A) est porté par une patte flexible (136B) qui se découpe dans la paroi latérale (132) du boîtier (131).

7. Module d'appareillage électrique (130) selon l'une des deux revendications précédentes, dans lequel ledit organe déployable (136A) est manœuvrable par un moyen (136C) qui est accessible au travers de ladite paroi avant (134).

8. Module d'appareillage électrique (130) selon l'une des revendications précédentes, dans lequel le boîtier (131) comporte des cloisons disposées dans ledit espace intérieur (142), qui viennent de formation avec une paroi arrière (133) fermant à l'arrière ladite paroi latérale (132) et/ou avec la paroi latérale (132), et qui délimitent un logement d'accueil et de blocage dudit élément de connexion électrique (141).

9. Module d'appareillage électrique (200 ; 400) selon l'une des revendications précédentes, dans lequel il est prévu une paroi arrière (133) qui ferme à l'arrière ladite paroi latérale (132) et qui présente au moins une ouverture d'entrée (140) pour la connexion dudit élément de connexion électrique (141) au réseau électrique local.

10. Module d'appareillage électrique (130) selon la revendication 9, dans lequel chaque élément de connexion électrique (141) comporte une borne à piston qui fait saillie à l'arrière de la paroi arrière (133), au travers de ladite ouverture d'entrée (140).

11. Module d'appareillage électrique (130) selon la revendication 10, dans lequel chaque élément de connexion électrique (141) comporte une borne fixe et indéformable située dans l'axe de ladite ouverture d'entrée (140).

12. Module d'appareillage électrique (130) selon l'une des revendications précédentes, dans lequel ledit trottoir extérieur (135) présente une face arrière inclinée vers l'extérieur.

13. Module d'appareillage électrique (130) selon l'une des revendications précédentes, dans lequel ledit trottoir extérieur (135) présente une face arrière au moins en partie crantée.

## Patentansprüche

1. Elektrisches Ausrüstungsmodul (130), das in eine elektrische Dose (110) einzusetzen ist, mit einem Steckdosen- oder Schalter- oder Wechselschaltermechanismus und einem Gehäuse (131) aus einem Isoliermaterial, das
- eine Seitenwand (132), die einen Innenraum (142) zur Aufnahme wenigstens eines elektrischen Verbindungselements (141) abgrenzt, und
- einen äußeren Umlauf (135), der die Seitenwand (132) vorne umgibt, um sich am vorderen Rand (115) der elektrischen Dose (110) abzustützen,
- einen Zierdeckel (139), der dem elektrischen Ausrüstungsmodul (130) dessen elektrische Funktion gibt und der entweder Durchgangsöffnungen für Stifte eines elektrischen Steckers oder eine Taste oder eine Abdeckplatte (150), die den Zierdeckel (139) des Gerätemechanismus umgibt, aufweist,
aufweist,
wobei das Gehäuse (131) eine Vorderwand (134) aufweist, die
- ein durch den Zierdeckel (139) verschlossenes Zugangsfenster (137) zu jedem elektrischen Verbindungselement (141) aufweist,
**dadurch gekennzeichnet, daß** die Vorderwand (134) den Innenraum (142) vorne abschließt, mit wenigstens einem Teil der Seitenwand (132) einstückig geformt ist und Mittel (138) zum Befestigen der Abdeckplatte (150) aufweist.

2. Elektrisches Ausrüstungsmodul (130) gemäß dem vorangehenden Anspruch, bei dem die Befestigungsmittel (138) zwischen dem Zugangsfenster (137) und dem äußeren Umlauf (135) angeordnet sind.

3. Elektrisches Ausrüstungsmodul (130) gemäß einem der vorangehenden Ansprüche, bei dem das Zugangsfenster 137) gegenüber dem Umfang der Vorderwand (134) außermittig ist.

4. Elektrisches Ausrüstungsmodul (130) gemäß einem der vorangehenden Ansprüche, bei dem die Seitenwand (132) eine im Wesentlichen kreiszylindrische Form um eine Achse (A1) hat.

5. Elektrisches Ausrüstungsmodul (130) gemäß einem der vorangehenden Ansprüche, bei dem das Gehäuse (131) wenigstens ein ausbreitbares Organ (136A) für die Befestigung des Gehäuses (131) an der elektrischen Dose (110) aufweist, das zwischen einer eingefahrenen Stellung, in der es das Einsetzen des Gehäuses (131) in die elektrische Dose (110) nicht behindert, und einer ausgefahrenen Stellung, in der es dazu ausgelegt ist, sich an der elektrischen Dose (110) festzuklammern, beweglich ist.

6. Elektrisches Ausrüstungsmodul (130) gemäß dem vorangehenden Anspruch, bei dem das ausbreitbare Organ (136A) von einem flexiblen Steg (136B) getragen wird, er aus der Seitenwand (132) des Gehäuses (131) ausgeschnitten ist.

7. Elektrisches Ausrüstungsmodul (130) gemäß einem der beiden vorangehenden Ansprüche, bei dem das ausbreitbare Organ (136A) durch ein Mittel (136C) bewegbar ist, das durch die Vorderwand (134) hindurch zugänglich ist.

8. Elektrisches Ausrüstungsmodul (130) gemäß einem der vorangehenden Ansprüche, bei dem das Gehäuse (131) im Innenraum (142) angeordnete Trennwände aufweist, die mit einer die Seitenwand (132) hinten abschließenden Rückwand (133) und/oder mit der Seitenwand (132) einstückig gebildet sind und die einen Aufnahme- und Blockierraum des elektrischen Verbindungselements (141) abgrenzen.

9. Elektrisches Ausrüstungsmodul (200; 400) gemäß einem der vorangehenden Ansprüche, bei dem eine Rückwand (133) vorgesehen ist, die die Seitenwand (132) hinten abschließt und die wenigstens eine Zugangsöffnung (140) für das Anschließen des elektrischen Verbindungselements (141) an das lokale elektrische Netz aufweist.

10. Elektrisches Ausrüstungsmodul (130) gemäß Anspruch 9, bei dem jedes elektrische Verbindungselement (141) einen Kolbenkontakt aufweist, der an der Rückseite der Rückwand (133) durch die Zugangsöffnung (140) herausragt.

11. Elektrisches Ausrüstungsmodul (130) gemäß Anspruch 10, bei dem jedes elektrische Verbindungselement (141) einen festen und nicht verformbaren Kontakt aufweist, der auf der Achse der Zugangsöffnung (140) liegt.

12. Elektrisches Ausrüstungsmodul (130) gemäß einem der vorangehenden Ansprüche, bei dem der äußere Umlauf (135) eine nach außen geneigte Rückseite aufweist.

13. Elektrisches Ausrüstungsmodul (130) gemäß einem der vorangehenden Ansprüche, bei dem der äußere Umlauf (135) eine wenigstens teilweise gerippte Rückseite aufweist.

## Claims

1. An electrical-accessory module (130) for engaging in an electrical box (110), comprising a power-outlet or an on/off or two-way switch mechanism, and a casing (131) that is made of insulating material and that comprises:
• a side wall (132) that defines an inside space (142) for receiving at least one electrical connection element (141);
• an outer collar (135) that borders the side wall (132) at the front so as to bear against the front edge (115) of said electrical box (110);
• a trim (139) that gives the electrical-accessory module (130) its electrical function and that comprises either openings for passing the pins of an electric plug, or a button ; and
• a finishing plate (150) bordering the trim (139),
wherein the casing (131) comprises a front wall (134) that includes an access window (137) for accessing each electrical connection element (141), said access window being closed by the trim (139);
**characterized in that** said front wall (134) closes said inside space (142) at the front and is made of a single piece with at least a part of said side wall (132), and comprises securing means (138) for securing said finishing plate (150).

2. An electrical-accessory module (130) according to the preceding claim, wherein said securing means (138) are situated between said access window (137) and said outer collar (135).

3. An electrical-accessory module (130) according to any preceding claim, wherein said access window (137) is off-center relative to the outline of said front wall (134).

4. An electrical-accessory module (130) according to any preceding claim, wherein said side wall (132) presents a shape that is substantially circularly-cylindrical about an axis (A1).

5. An electrical-accessory module (130) according to any preceding claim, wherein said casing (131) includes at least one deployable member (136A) for fastening the casing (131) to said electrical box (110), which deployable member is movable between a retracted position in which it does not hinder insertion of the casing (131) into said electrical box (110), and a deployed position in which it is adapted to catch onto said electrical box (110) .

6. An electrical-accessory module (130) according to the preceding claim, wherein said deployable member (136A) is carried by a flexible tab (136B) that is cut out in the side wall (132) of the casing (131).

7. An electrical-accessory module (130) according to any one of the two preceding claims, wherein said deployable member (136A) is movable by means (136C) that are accessible through said front wall (134).

8. An electrical-accessory module (130) according to any preceding claim, wherein the casing (131) includes partitions that are arranged in said inside space (142), which partitions are formed integrally with a rear wall (133) that closes said side wall (132) at the rear and/or with the side wall (132), and define a housing for receiving and blocking said electrical-connection element (141) .

9. An electrical-accessory module (200; 400) according to any preceding claim, wherein a rear wall (133) is provided that closes said side wall (132) at the rear, and that presents at least one inlet opening (140) for connecting said electrical connection element (141) to the local electricity network.

10. An electrical-accessory module (130) according to claim 9, wherein each electrical connection element (141) comprises a piston terminal that projects at the rear of the rear wall (133), through said inlet opening (140).

11. An electrical-accessory module (130) according to claim 10, wherein each electrical connection element (141) comprises a stationary and non-deformable terminal that is situated on the axis of said inlet opening (140).

12. An electrical-accessory module (130) according to any preceding claim, wherein said outer collar (135) presents a rear face that slopes outwards.

13. An electrical-accessory module (130) according to any preceding claim, wherein said outer collar (135) presents a rear face that is serrated at least in part.
